# EUROPEAN PATENT SPECIFICATION

(11) **EP 4 226 492 B1**
(45) Date of publication and mention of the grant of the patent: **09.12.2026**
(21) Application number: 21878501.2
(22) Date of filing: 07.10.2021
(51) Int. Cl.: H02M 3/156, H02M 1/00

(54) **DC-DC CONVERTER WITH ADAPTIVE ZERO TRACKING**
GLEICHSTROMWANDLER MIT ADAPTIVER NULLNACHFÜHRUNG
CONVERTISSEUR CC-CC À DÉTECTION DE PASSAGE PAR ZÉRO ADAPTATIVE

(30) Priority: 07.10.2020 US 202063088773 P; 30.09.2021 US 202117490764
(43) Date of publication of application: 16.08.2023
(73) Proprietor: Texas Instruments Incorporated, Dallas, TX 75265 (US)
(72) Inventor: SEETHARAMAN, Narayanan, 85356 Freising (DE); BECKER FERREIRA, Julian, Leonhard, 85356 Freising (DE); SAREEN, Puneet, 85356 Freising (DE); DIETRICH, Stefan, 85445 Freising (DE)
(74) Representative: Zeller, Andreas
(86) International application number: PCT/US2021/053881
(87) International publication number: WO 2022/076635

(56) References cited:
- KR-A- 20120 045 385
- US-A1- 2005 001 597
- US-A1- 2015 155 783
- US-A1- 2020 274 447
- US-B1- 7 821 238
- US-B2- 8 957 661

## Description

### BACKGROUND

A switch-mode power supply is an electronic circuit that converts an input direct current (DC) supply voltage into one or more DC output voltages that are higher or lower in magnitude than the input DC supply voltage. A switch-mode power supply that generates an output voltage lower than the input voltage is termed a buck or step-down converter. A switch-mode power supply that generates an output voltage higher than the input voltage is termed a boost or step-up converter. The stability of the switch-mode power supply may be compromised by gain and phase-shift introduced in the control loop of the power supply. Compensation may be applied in a switch-mode power supply to counteract the gain and phase shift. KR 2012 0045385 A discloses an output voltage stability circuit of a Direct Current (DC)/DC converter. Further, US 2020/274447 A1 discloses a circuit including a DC/DC buck-boost converter and a controller.

### SUMMARY

The invention is defined by the features of independent claim 1. Preferred embodiments are described in the dependent claims.

### BRIEF DESCRIPTION OF THE DRAWINGS

FIG. 1 is a graph of signals in a DC-DC converter exhibiting pulse grouping in pulse frequency mode (PFM) operation.
FIG. 2 is a block diagram for an example DC-DC converter that includes compensation zero-tracking based on switching frequency.
FIG. 3 is a schematic diagram for an example compensation circuit that includes compensation zero-tracking based on switching frequency.
FIG. 4 is a bode diagram for an example of the compensation circuit of FIG. 3.
FIG. 5 is a graph of signals in a DC-DC converter that includes an example of the compensation circuit of FIG. 3.
FIG. 6 is a graph showing change in duty cycle applied in the compensation circuit of FIG. 3 with decreasing load.
FIG. 7 is a schematic diagram for an example compensation circuit that includes compensation zero-tracking based on switching frequency.
FIG. 8 is a bode diagram for an example of the compensation circuit of FIG. 7.
FIG. 9 is a graph of signals in a DC-DC converter that includes an example of the compensation circuit of FIG. 7.
FIGS. 10A-10C are a graphs of magnified signals shown in the graph of FIG. 9.

### DETAILED DESCRIPTION OF EXAMPLE EMBODIMENTS

Compensation circuits are employed to stabilize the control loop in DC-DC converters and other feedback loop-controlled circuits. The type (e.g., type-1, type-2, or type-3) of compensation circuit employed is selected based on various parameters (e.g., output filter component type and size, switching frequency, bandwidth, etc.) of the circuit being controlled. Type-2 compensation is widely used in DC-DC converters. For example, type-2 compensation may be used in applications where the frequency of the zero caused by the circuit output capacitor and its equivalent series resistance is smaller than the closed loop bandwidth of the control loop.

DC-DC converters that use voltage-controlled oscillator (VCO) based pulse frequency mode (PFM) in light load conditions suffer from phase margin degradation due to the switching frequency pole. Pulse width modulation (PWM) based DC-DC converters that implement pulse skipped mode (PSM) operation exhibit similar phase margin degradation. When the phase margin degradation results in negative phase margins, instability in the form of pulse grouping results.

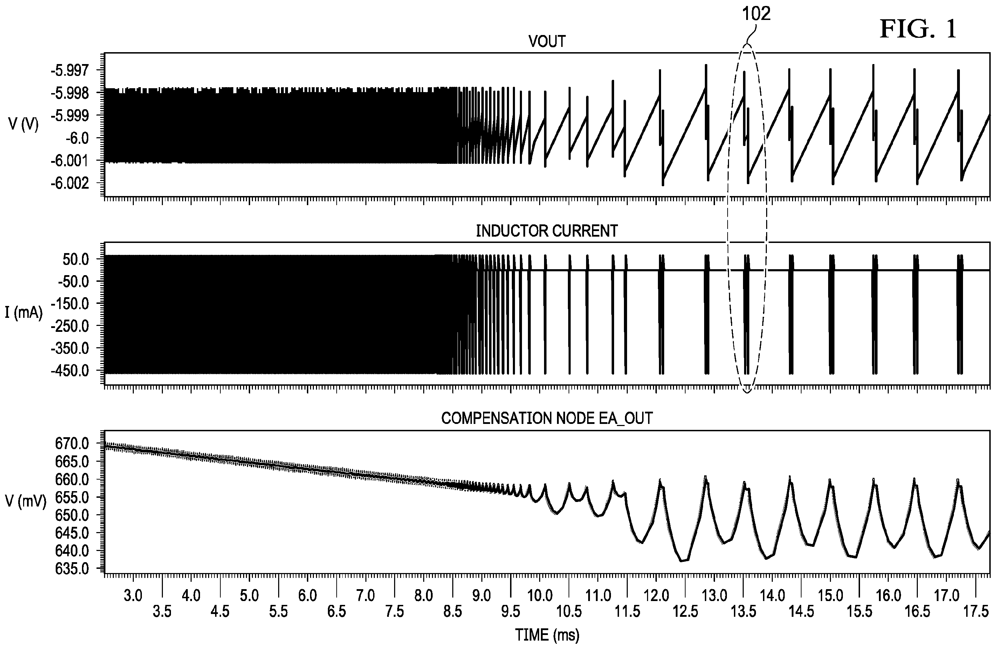

FIG. 1 shows signals in a DC-DC converter exhibiting pulse grouping in pulse frequency mode (PFM) operation. In this example, the DC-DC converter is an inverting buck-boost converter with type-2 compensation. The load applied to the DC-DC converter decreases over time. As the DC-DC converter's switching frequency decreases with the decreasing load, pulse grouping or bursting occurs in the switching (see region 102). Some DC-DC converters attempt to avoid this behavior by using a dummy load to limit the switching frequency of the DC-DC converter, which limits the bandwidth of the converter, and reduces efficiency with light loads.

The DC-DC converters described herein track the zero of the type-2 compensation circuit with converter switching frequency to maintain phase margin across the entire switching frequency range of the DC-DC converter. By maintaining phase margin, the DC-DC converters avoid pulse grouping with light loads.

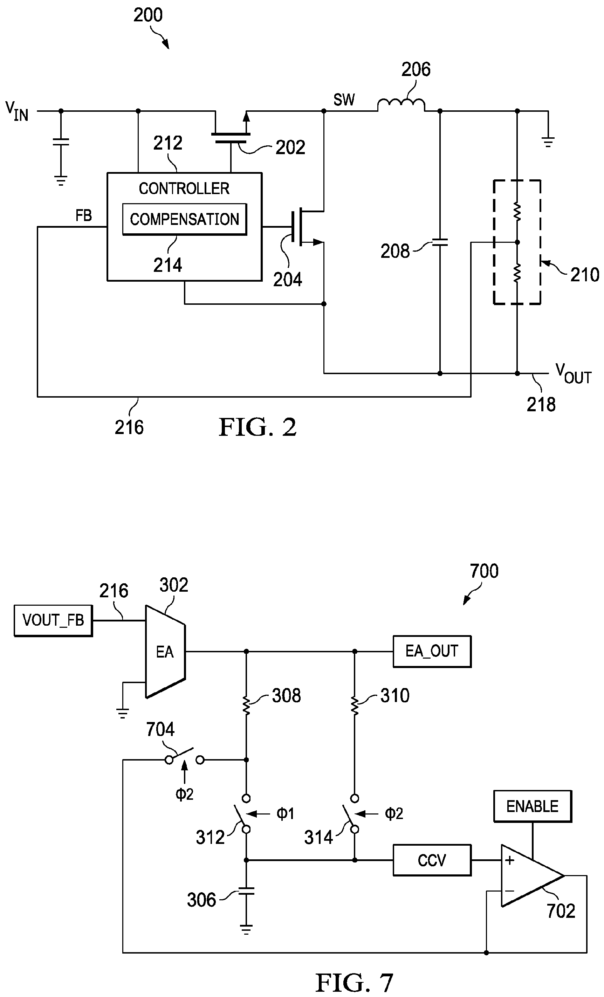

FIG. 2 is a block diagram for an example DC-DC converter 200 that includes compensation zero-tracking based on switching frequency. The DC-DC converter 200 includes a high-side transistor 202, a low-side transistor 204, an inductor 206, an output capacitor 208, a voltage divider 210, and a controller 212. The DC-DC converter 200 is configured as an inverting buck-boost converter. Some examples of the DC-DC converter 200 may be configured as a buck converter, a boost converter, a buck-boost converter, or other type of DC-DC converter.

The controller 212 controls switching of the high-side transistor 202 and the low-side transistor 204 to provide a selected output voltage (VOUT) at the output 218. The voltage divider 210 is coupled to the controller 212 for provision of output voltage feedback 216 to the controller 212. The controller 212 controls switching of the high-side transistor 202 and the low-side transistor 204 based on the output voltage feedback 216 received from the voltage divider 210. The controller 212 includes a compensation circuit 214 to stabilize control of VOUT generation. The compensation circuit 214 tracks the zero of the compensation circuit 214 with converter switching frequency to maintain phase margin across the entire switching frequency range of the DC-DC converter 200.

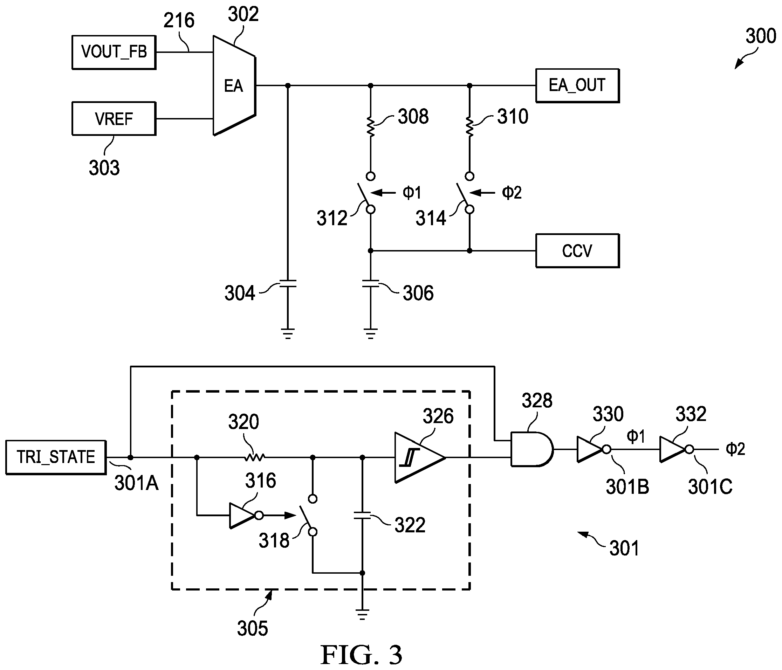

FIG. 3 is a schematic level diagram for an example compensation circuit 300 that includes compensation zero-tracking based on switching frequency. The compensation circuit 300 is an example of the compensation circuit 214. The compensation circuit 300 includes an error amplifier 302, a capacitor 304, a capacitor 306, a resistor 308, a resistor 310, a switch 312, a switch 314, and a switch control circuit 301. The error amplifier 302 includes an input coupled to the voltage divider 210 for receipt of the output voltage feedback 216, and an input coupled to a voltage reference circuit 303. The error amplifier 302 generates an error signal representative of the difference between the output voltage feedback 216 and the reference voltage received from the voltage reference circuit 303.

The capacitor 304 is coupled to the output of the error amplifier 302. The resistor 308 includes a first terminal coupled to the output of the error amplifier 302, and a second terminal coupled to a first terminal of the switch 312. A second terminal of the switch 312 is coupled to a first terminal of the capacitor 306. A second terminal of the capacitor 306 is coupled to ground. The resistor 310 includes a first terminal coupled to the output of the error amplifier 302, and a second terminal coupled to a first terminal of the switch 314. A second terminal of the switch 314 is coupled to a first terminal of the capacitor 306. The switch 312 and the switch 314 may be implemented using field effect transistors (FETs) in some implementations of the compensation circuit 300. The resistance of the resistor 310 may greater (e.g., 10 time greater) than the resistance of the resistor 308.

The switch control circuit 301 controls switching of the switch 312 and the switch 314 to vary the resistance coupling the output of the error amplifier 302 to the capacitor 306, and vary the location of the zero corresponding to the resistance. The switch control circuit 301 include a phase output 301B that is coupled to a control terminal of the switch 312 and a phase output 301C that is coupled to a control terminal of the switch 314. A signal Φ1 (a switch control signal) generated by the switch control circuit 301 controls switching of the switch 312, and a signal Φ2 (a switch control signal) generated by the switch control circuit 301 controls switching of the switch 314. The signals Φ1 and Φ2 may be complementary. Accordingly, the signal Φ2 may be inverted relative to (an inverted version of) the signal Φ1. Accordingly, the switch 312 is closed when the switch 314 is open, and the switch 312 is open when the switch 314 is closed, and the switch control circuit 301 complementarily couples the resistors 308 and 310 to the capacitor 306.

The switch control circuit 301 includes an input terminal 301A that is coupled to a control terminal of the high-side transistor 202 or a control terminal of the low-side transistor 204. The switch control circuit 301 includes a logic gate 328, an inverter 330, an inverter 332, and a delay circuit 305. A first input of the logic gate 328 is coupled to the input terminal 301A, and a second input of the logic gate 328 is coupled to the output of the delay circuit 305. The logic gate 328 combines the signal at the input terminal 301A and the delayed signal output by the delay circuit 305 to produce a control signal for controlling the switch 312 and the switch 314. The output of the logic gate 328 is coupled to an input of the inverter 330, and an output of the inverter 330 (the phase output 301B) is coupled to an input of the inverter 332. The output of the inverter 332 is coupled to the phase output 301C.

The delay circuit 305 includes an inverter 316, a switch 318, a resistor 320, a capacitor 322, and a Schmitt trigger 326. A first terminal of the resistor 320 is coupled to the input terminal 301A and the input of the inverter 316. A second terminal of the resistor 320 is coupled to an input of the Schmitt trigger 326, a first terminal of the switch 318, and a first terminal of the capacitor 322. The output of the inverter 316 is coupled to a control terminal of the switch 318. A second terminal of the switch 318 and a second terminal of the capacitor 322 are coupled to ground. The switch 318 discharges the capacitor 322 when the signal at the input terminal 301A is low. The switch 318 may be implemented using a FET in some implementations of the delay circuit 305. The duty cycles of the signals Φ1 and Φ2 generated by the switch control circuit 301 change with the frequency of the switching control signal received at the input terminal 301A. The resistance between the output of the error amplifier 302 and the capacitor 306 changes with the duty cycle of the signals Φ1 and Φ2. The resistance decreases as switching frequency increases, and increases as switching frequency decreases.

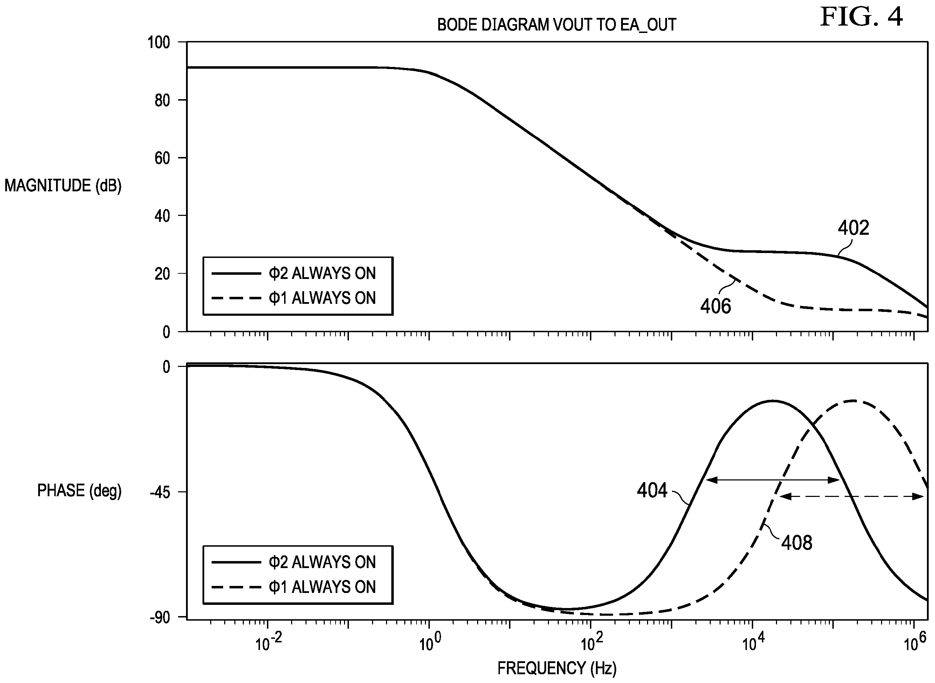

FIG. 4 is a bode diagram for an example of the compensation circuit 300. The curves 402 and 404 represent magnitude and phase when the signal Φ2 is always on (lower switching frequency), and show a phase boost in a lower frequency region (e.g., 2-100 kilohertz). The curves 406 and 408 represent magnitude and phase when the signal Φ1 is always on (higher switching frequency), and show a phase boost in a higher frequency region (20 kilohertz to one megahertz). By modulating the duty cycle of the signals Φ1 and Φ2 with switching frequency, the effective resistance applied in the compensation circuit 300 varies such that the effective phase curve lies between the curves 404 and 408.

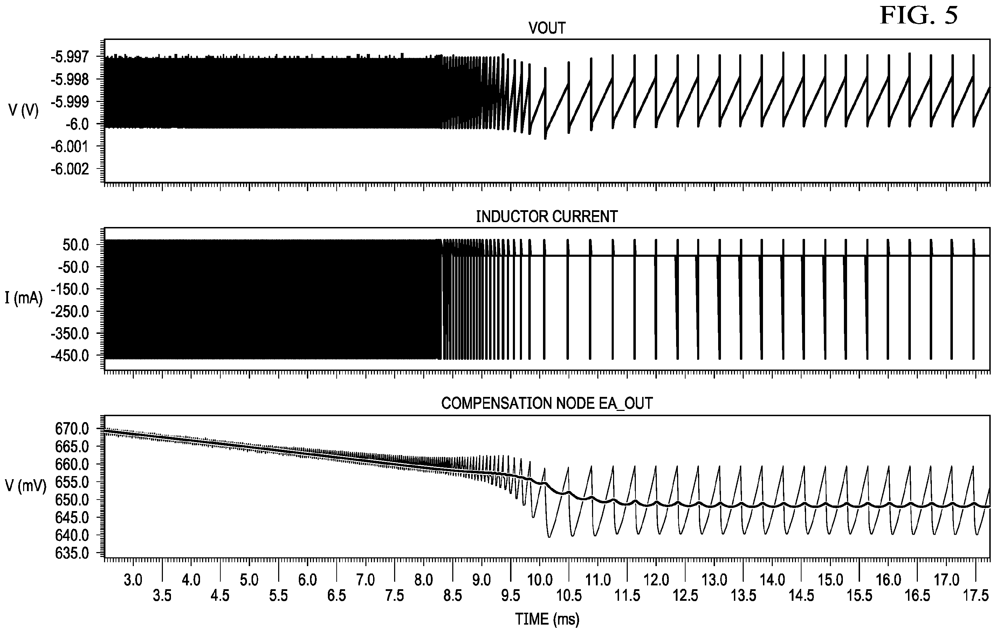

FIG. 5 is a graph of signals in an implementation of the DC-DC converter 200 that includes the compensation circuit 300. In FIG. 5, the load applied to the DC-DC converter 200 is linearly reduced over time. Output voltage, current in the inductor 206, and output of the error amplifier 302 are shown in FIG. 5. The reduction in load causes the switching frequency of the DC-DC converter 200 to decrease. As the switching frequency of the DC-DC converter 200 decreases, the compensation circuit 300 varies the compensation resistance to avoid the pulse grouping shown in FIG. 1.

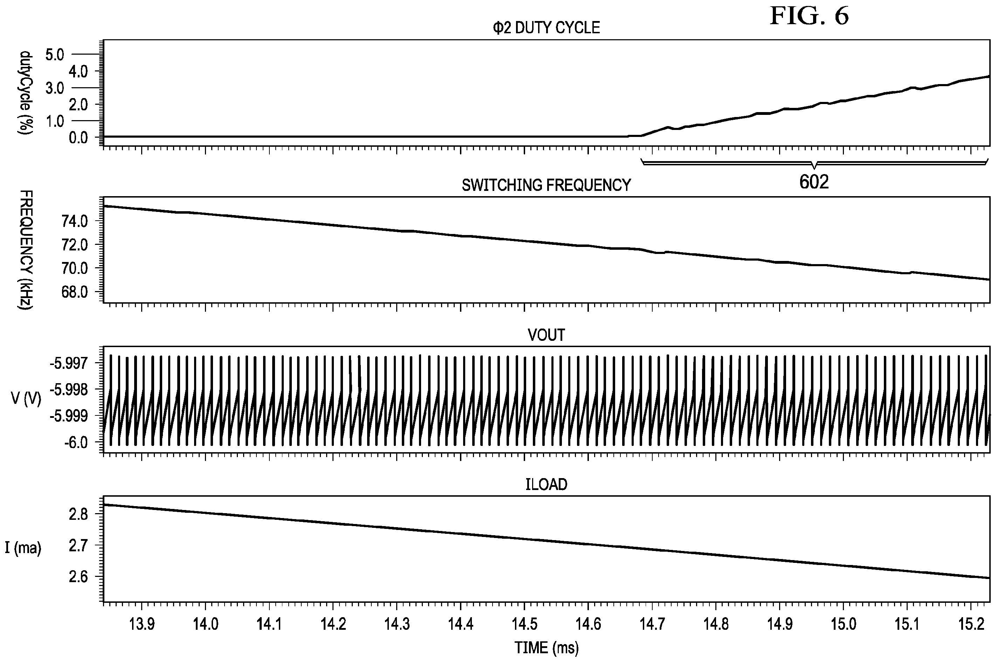

FIG. 6 is a graph showing change in duty cycle applied in the compensation circuit 300 with decreasing load. As the load decreases, the inductor current and switching frequency of the DC-DC converter 200 also decreases, and the duty cycle of the signal Φ2 smoothly increases (interval 602). No undesirable perturbations in the output voltage are present.

FIG. 7 is a schematic diagram for an example compensation circuit 700 that includes compensation zero-tracking based on switching frequency. The compensation circuit 700 is similar to the compensation circuit 300, and adds capacitance multiplication circuitry. The compensation circuit 700 includes the error amplifier 302, the capacitor 306, the resistor 308, the resistor 310, the switch 312, the switch 314, and the switch control circuit 301 (not shown) as described with respect to the compensation circuit 300.

The compensation circuit 700 further includes an amplifier 702 and a switch 704. The amplifier 702 is a buffer amplifier (e.g., a unity gain buffer). A terminal of the amplifier 702 is coupled to the first terminal of the capacitor 306. The output of the amplifier 702 is coupled to a second input of the amplifier 702, and to a first terminal of the switch 704. A second terminal of the switch 704 is coupled to the first terminal of the switch 312. A control terminal of the switch 704 is coupled to the control terminal of the switch 312. When the switches switch 314 and switch 704 are closed, a capacitance multiplier circuit is formed using the amplifier 702. The switch 704 may implemented using a FET.

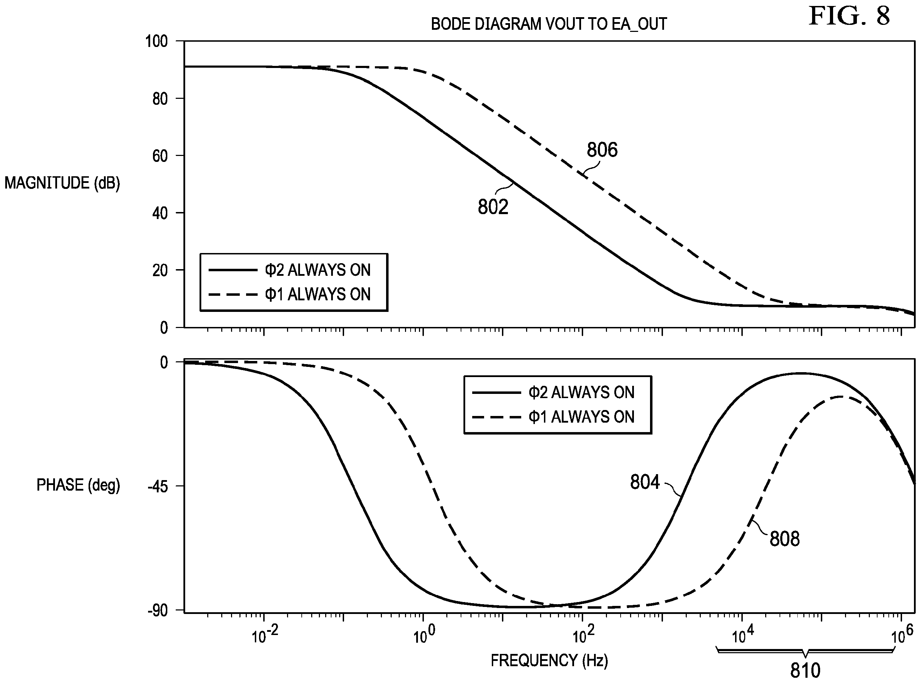

FIG. 8 is a bode diagram for an example of the compensation circuit 700. The curves 802 and 804 represent magnitude and phase when the signal Φ2 is always on (lower switching frequency), and show a phase boost in a lower frequency region (e.g., 20 kilohertz to 1 megahertz). The curves 806 and 808 represent magnitude and phase when the signal Φ1 is always on (higher switching frequency), and show a phase boost in a higher frequency region (20 kilohertz to 1 megahertz). By modulating the duty cycle of the signals Φ1 and Φ2 with switching frequency, the effective capacitance of the compensation circuit is controlled, and the region of phase boost 810 is extended with switching frequency. Gain in the region of phase boost 810 remains relatively constant.

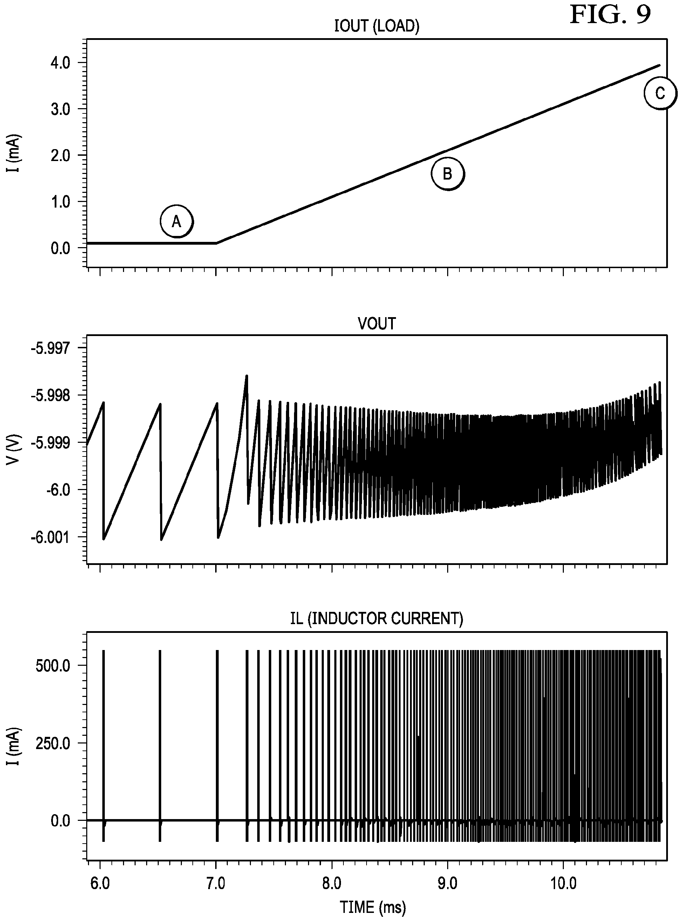

FIG. 9 is a graph of signals in a DC-DC converter that includes an example of the compensation circuit 700. In FIG. 9, load current increases from about 100 microamperes (at time A) to about 4 milliamperes (at time C) over time. The change in load has little impact on the output voltage, and the inductor current and output voltage show that no pulse grouping is present.

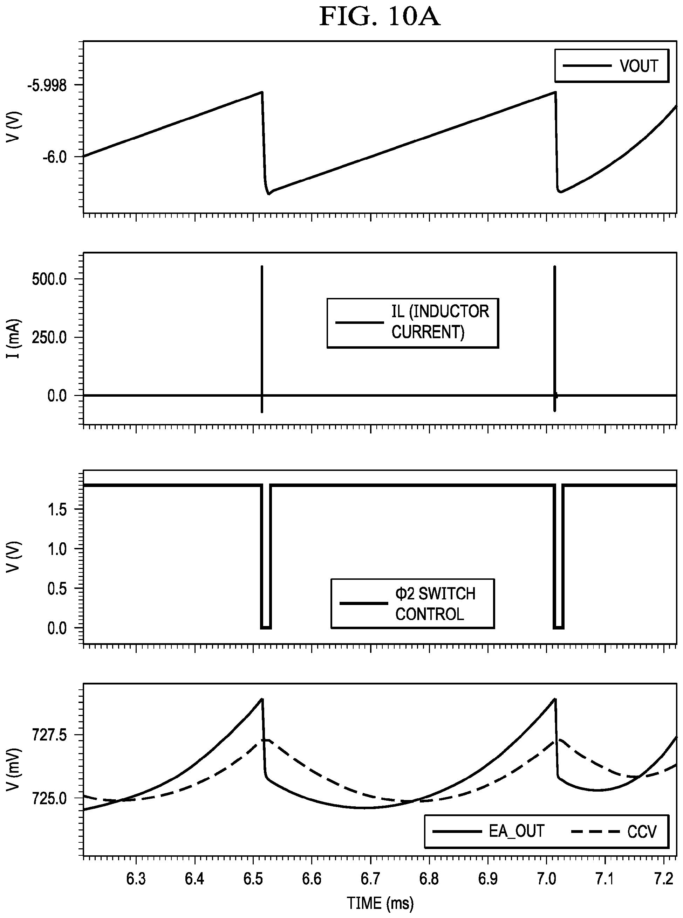

FIGS. 10A-10C are graphs of magnified signals from the graph of FIG. 9. FIG. 10A zooms in on the signals of the graph of FIG. 9 at time A (about 100 microamperes of load current). The DC-DC converter switching frequency is about 2 kilohertz. The signal Φ2 is activated after each switching operation with delay. Due to the low switching frequency, the signal Φ2 is high, and the capacitance multiplier of the compensation circuit 700, is active most of the time to provide a phase-boost.

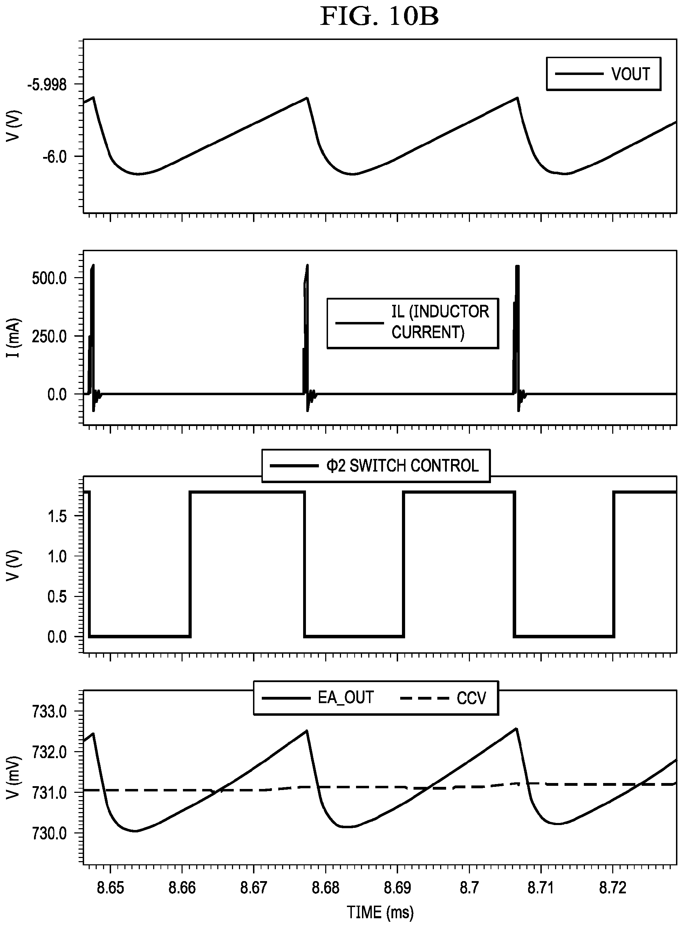

FIG. 10B zooms in on the signals of the graph of FIG. 9 at time B (about 1.8 milliamperes of load current). The DC-DC converter switching frequency is about 33 kilohertz. The signal Φ2 is activated after each switching operation with delay. The signal Φ2 is high and the capacitance multiplier of the compensation circuit 700 is active about half of the time.

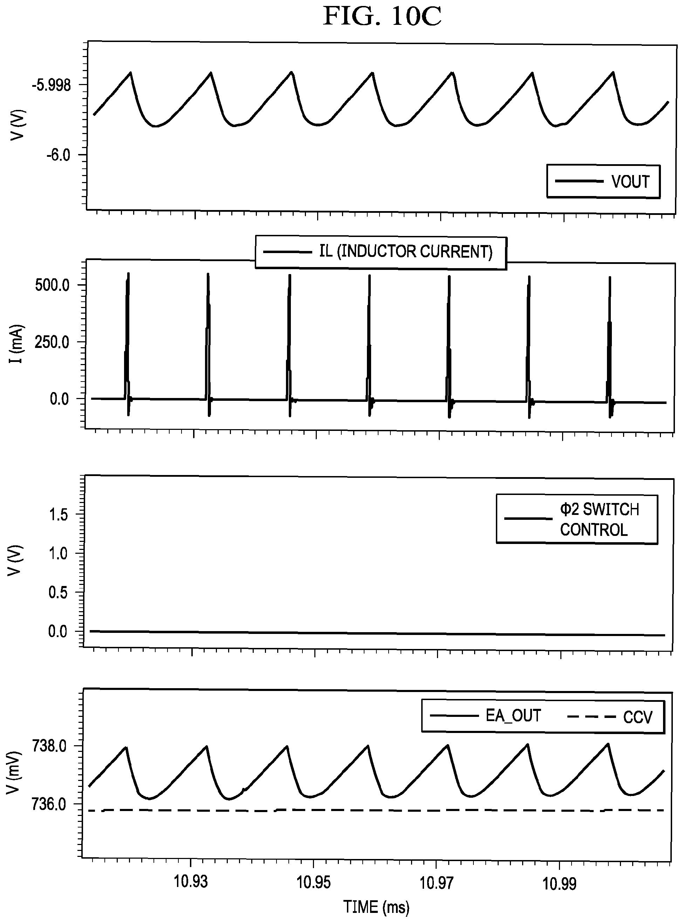

FIG. 10C zooms in on the signals of the graph of FIG. 9 at time C (about 4 milliamperes of load current). The DC-DC converter switching frequency is about 77 kilohertz. The signal Φ2 is not activated (the signal Φ1 is always active), and the capacitance multiplier of the compensation circuit 700 is off. Because of the higher switching frequency, no phase boost in the lower frequency range is needed.

In this description, the term "couple" may cover connections, communications or signal paths that enable a functional relationship consistent with this description. For example, if device A generates a signal to control device B to perform an action, then: (a) in a first example, device A is directly coupled to device B; or (b) in a second example, device A is indirectly coupled to device B through intervening component C if intervening component C does not substantially alter the functional relationship between device A and device B, so device B is controlled by device A via the control signal generated by device A.

## Claims

1. A DC-DC converter (200), comprising:
an error amplifier (302) including an output;
a compensation circuit (214, 300, 700) including:
a first resistor (308) including:
a first terminal coupled to the output of the error amplifier (302); and
a second terminal;
a first switch (312) including:
a first terminal coupled to the second terminal of the first resistor (308); and
a second terminal;
a second resistor (310) including:
a first terminal coupled to the output of the error amplifier (302); and
a second terminal;
a second switch (314) including:
a first terminal coupled to the second terminal of the second resistor (310); and
a second terminal coupled to the second terminal of the first switch (312);
a capacitor (306) including:
a first terminal coupled to the second terminal of the first switch (312); and
a second terminal coupled to ground; and
a switch control circuit (301) including an input terminal (301A), configured to:
generate a first switch control signal (Φ1) to control switching of the first switch (312), and generate a second switch control signal (Φ2) to control switching of the second switch (314),
**characterized in that**
wherein the duty cycles of the first and second switch control signals (Φ1, Φ2) are configured to change with the switching frequency of the DC-DC converter (200) received at the input terminal (301A), wherein the switch control circuit (301) is configured to, by means of the first and second switch control signals (Φ1, Φ2), close the first switch (312) when the second switch (314) is open, and open the first switch (312) when the second switch (314) is closed, and the switch control circuit (301) is configured to complementarily couple the first and second resistors (308, 310) to the capacitor (306) by means of the first and second switch control signals (Φ1, Φ2).

2. The DC-DC converter of claim 1, wherein the compensation circuit (700) includes:
a buffer amplifier (702) including:
an input coupled to the first terminal of the capacitor (306); and
an output coupled to the first terminal of the first switch (312).

3. The DC-DC converter of claim 2, wherein the compensation circuit (700) includes:
a third switch (704) including:
a first terminal coupled to the output of the buffer amplifier (702); and
a second terminal coupled to the first terminal of the first switch (312).

4. The DC-DC converter of claim 1, wherein:
the first switch (312) includes a control terminal;
the second switch (314) includes a control terminal; and
the compensation circuit (300) includes a switch control circuit (301) including:
a first phase output (301B) coupled to the control terminal of the first switch (312); and
a second phase output (301C) coupled to the control terminal of the second switch (314).

5. The DC-DC converter of claim 4, wherein the switch control circuit (301) includes:
an input terminal (301A);
a logic gate (328), including
a first input coupled to the input terminal (301A);
a second input; and
an output;
a delay circuit (305) including:
an input coupled to the input terminal (301A); and
an output coupled to the second input of the logic gate (328);
a first inverter (330) including:
an input coupled to the output of the logic gate (328); and
an output coupled to the first phase output (301B); and
a second inverter (332) including:
an input coupled to the output of the first inverter (330); and
an output coupled to the second phase output (301C).

6. The DC-DC converter of claim 5, wherein the delay circuit (305) includes:
a third resistor (320) including:
a first terminal coupled to the first input of the logic gate (328); and
a second terminal;
a Schmitt trigger (326) including:
an input coupled to the second terminal of the third resistor (320); and
an output coupled to the second input of the logic gate (328); and
a third capacitor (322) including:
a first terminal coupled to the second terminal of the third resistor (320); and
a second terminal coupled to ground.

7. The DC-DC converter of claim 6, wherein the delay circuit (305) includes:
a third switch (318) including:
a first terminal coupled to the second terminal of the third resistor (320);
a second terminal coupled to ground; and
a control terminal; and
a third inverter (316) including:
an input coupled to the first terminal of the third resistor (320); and
an output coupled to the control terminal of the third switch (318).

8. The DC-DC converter of claim 1, comprising:
an output terminal;
a reference voltage source (303);
an error amplifier (302) coupled to the output terminal and the reference voltage source (303), and configured to generate an error signal representative of a difference between a voltage at the output terminal and a reference voltage provided by the reference voltage source (303);
the compensation circuit (300, 700) coupled to the error amplifier (302), and comprising:
the first resistor (308) coupled to the error amplifier (302); and
the capacitor (306) coupled to the first resistor (308); and
the switch control circuit (301) configured to modulate connection of the first resistor (308) to the capacitor (306) based on the switching frequency of the DC-DC converter (200).

9. The DC-DC converter of claim 8, wherein:
the compensation circuit (300, 700) includes the first switch (312) configured to couple the first resistor (308) to the capacitor (306); and
the first switch (312) is coupled to the switch control circuit (301) to modulate the connection of the first resistor (308) to the capacitor (306).

10. The DC-DC converter of claim 9, wherein:
the compensation circuit (300, 700) includes:
the second resistor (310) coupled to the error amplifier (302); and
the second switch (314) configured to couple the second resistor (310) to the capacitor (306); and
the second switch (314) is coupled to the switch control circuit (301) to modulate the connection of the second resistor (310) to the capacitor (306).

11. The DC-DC converter of claim 10, wherein:
the switch control circuit (301) is configured to complementarily couple the first resistor (308) and the second resistor (310) to the capacitor (306); and
time of connection of the first resistor (308) to the capacitor (306) increases with increase of the switching frequency of the DC-DC converter (200).

12. The DC-DC converter of claim 10, wherein a resistance of the second resistor (310) is greater than a resistance of the first resistor (308).

13. The DC-DC converter of claim 10, wherein:
the switch control circuit (301) is configured to:
generate the first switch control signal (Φ1) to modulate the first switch (312); and
generate the second switch control signal (Φ2) to modulate the second switch (314); and
the second switch control signal (Φ2) is an inverted version of the first switch control signal (Φ1).

14. The DC-DC converter of claim 10, wherein:
the compensation circuit (700) includes:
a capacitance multiplier circuit including:
a buffer amplifier (702) including:
an input coupled to a terminal of the capacitor (306); and
an output; and
a third switch (704) coupled between the output of the buffer amplifier (702) and the first switch (312); and
the second switch control signal (Φ2) modulates the third switch (704).

## Patentansprüche

1. DC/DC-Wandler (200), der Folgendes umfasst:
einen Fehlerverstärker (302), der einen Ausgang aufweist;
eine Kompensationsschaltung (214, 300, 700), die Folgendes aufweist:
einen ersten Widerstand (308), der Folgendes aufweist:
einen ersten Anschluss, der mit dem Ausgang des Fehlerverstärkers (302) gekoppelt ist; und
einen zweiten Anschluss;
einen ersten Schalter (312), der Folgendes aufweist:
einen ersten Anschluss, der mit dem zweiten Anschluss des ersten Widerstands (308) gekoppelt ist; und
einen zweiten Anschluss;
einen zwei Widerstand (310), der Folgendes aufweist:
einen ersten Anschluss, der mit dem Ausgang des Fehlerverstärkers (302) gekoppelt ist; und
einen zweiten Anschluss;
einen zweiten Schalter (314), der Folgendes aufweist:
einen ersten Anschluss, der mit dem zweiten Anschluss des zweiten Widerstands (310) gekoppelt ist; und
einen zweiten Anschluss, der mit dem zweiten Anschluss des ersten Schalters (312) gekoppelt ist;
einen Kondensator (306), der Folgendes aufweist:
einen ersten Anschluss, der mit dem zweiten Anschluss des ersten Schalters (312) gekoppelt ist; und
einen zweiten Anschluss, der mit Masse gekoppelt ist; und
eine Schaltersteuerschaltung (301), die einen Eingangsanschluss (301A) aufweist, der ausgelegt ist zum:
Erzeugen eines ersten Schaltersteuersignals (Φ1) zum Steuern des Schaltens des ersten Schalters (312) und Erzeugen eines zweiten Schaltersteuersignals (Φ2) zum Steuern des Schaltens des zweiten Schalters (314),
**dadurch gekennzeichnet, dass**
wobei die Tastgrade des ersten und des zweiten Schaltersteuersignals (Φ1, Φ2) dazu ausgelegt sind, sich mit der Schaltfrequenz des DC-DC-Wandlers (200) zu ändern, die am Eingangsanschluss (301A) empfangen wird, wobei die Schaltersteuerschaltung (301) dazu ausgelegt ist, mittels des ersten und des zweiten Schaltersteuersignals (Φ1, Φ2) den ersten Schalter (312) zu schließen, wenn der zweite Schalter (314) geöffnet ist, und den ersten Schalter (312) zu öffnen, wenn der zweite Schalter (314) geschlossen ist, und die Schaltersteuerschaltung (301) dazu ausgelegt ist, den ersten und den zweiten Widerstand (308, 310) mittels des ersten und des zweiten Schaltersteuersignals (Φ1, Φ2) komplementär mit dem Kondensator (306) zu koppeln.

2. DC-DC-Wandler nach Anspruch 1, wobei die Kompensationsschaltung (700) Folgendes aufweist:
einen Pufferverstärker (702), der Folgendes aufweist:
einen Eingang, der mit dem ersten Anschluss des Kondensators (306) gekoppelt ist; und
einen Ausgang, der mit dem ersten Anschluss des ersten Schalters (312) gekoppelt ist.

3. DC-DC-Wandler nach Anspruch 2, wobei die Kompensationsschaltung (700) Folgendes aufweist:
einen dritten Schalter (704), der Folgendes aufweist:
einen ersten Anschluss, der mit dem Ausgang des Pufferverstärkers (702) gekoppelt ist; und
einen zweiten Anschluss, der mit einem ersten Anschluss des ersten Schalters (312) gekoppelt ist.

4. DC/DC-Wandler nach Anspruch 1, wobei:
der erste Schalter (312) einen Steueranschluss aufweist;
der zweite Schalter (314) einen Steueranschluss aufweist; und
die Kompensationsschaltung (300) eine Schaltersteuerschaltung (301) aufweist, die Folgendes aufweist:
einen ersten Phasenausgang (301B), der mit dem Steueranschluss des ersten Schalters (312) gekoppelt ist; und
einen zweiten Phasenausgang (301C), der mit dem Steueranschluss des zweiten Schalters (314) gekoppelt ist.

5. DC/DC-Wandler nach Anspruch 4, wobei die Schaltersteuerschaltung (301) Folgendes aufweist:
einen Eingangsanschluss (301A);
ein Logikgatter (328), das Folgendes aufweist:
einen ersten Eingang, der mit dem Eingangsanschluss (301A) gekoppelt ist;
einen zweiten Eingang; und
einen Ausgang;
eine Verzögerungsschaltung (305), die Folgendes aufweist:
einen Eingang, der mit dem Eingangsanschluss (301A) gekoppelt ist; und
einen Ausgang, der mit dem zweiten Eingang des Logikgatters (328) gekoppelt ist;
einen ersten Inverter (330), der Folgendes aufweist:
einen Eingang, der mit dem Ausgang des Logikgatters (328) gekoppelt ist; und
einen Ausgang, der mit dem ersten Phasenausgang (301B) gekoppelt ist; und
einen zweiten Inverter (332), der Folgendes aufweist:
einen Eingang, der mit dem Ausgang des ersten Inverters (330) gekoppelt ist; und
einen Ausgang, der mit dem zweiten Phasenausgang (301C) gekoppelt ist.

6. DC-DC-Wandler nach Anspruch 5, wobei die Verzögerungsschaltung (305) Folgendes aufweist:
einen dritten Widerstand (320), der Folgendes aufweist:
einen ersten Anschluss, der mit dem ersten Eingang des Logikgatters (328) gekoppelt ist; und
einen zweiten Anschluss;
einen Schmitt-Trigger (326), der Folgendes aufweist:
einen Eingang, der mit dem zweiten Anschluss des dritten Widerstands (320) gekoppelt ist; und
einen Ausgang, der mit dem zweiten Eingang des Logikgatters (328) gekoppelt ist; und
einen dritten Kondensator (322), der Folgendes aufweist:
einen ersten Anschluss, der mit dem zweiten Anschluss des dritten Widerstands (320) gekoppelt ist; und
einen zweiten Anschluss, der mit Masse gekoppelt ist.

7. DC-DC-Wandler nach Anspruch 6, wobei die Verzögerungsschaltung (305) Folgendes aufweist:
einen dritten Schalter (318), der Folgendes aufweist:
einen ersten Anschluss, der mit dem zweiten Anschluss des dritten Widerstands (320) gekoppelt ist;
einen zweiten Anschluss, der mit Masse gekoppelt ist; und
einen Steueranschluss; und
einen dritten Inverter (316), der Folgendes aufweist:
einen Eingang, der mit dem ersten Anschluss des dritten Widerstands (320) gekoppelt ist; und
einen Ausgang, der mit dem Steueranschluss des dritten Schalters (318) gekoppelt ist.

8. DC/DC-Wandler nach Anspruch 1, der Folgendes umfasst:
einen Ausgangsanschluss;
eine Referenzspannungsquelle (303);
einen Fehlerverstärker (302), der mit dem Ausgangsanschluss und der Referenzspannungsquelle (303) gekoppelt ist und dazu ausgelegt ist, ein Fehlersignal zu erzeugen, das eine Differenz zwischen einer Spannung am Ausgangsanschluss und einer Referenzspannung, die durch die Referenzspannungsquelle (303) bereitgestellt wird, repräsentiert;
wobei die Kompensationsschaltung (300, 700) mit dem Fehlerverstärker (302) gekoppelt ist und Folgendes umfasst:
der erste Widerstand (308) ist mit dem Fehlerverstärker (302) gekoppelt; und
der Kondensator (306) ist mit dem ersten Widerstand (308) gekoppelt; und
die Schaltersteuerschaltung (301) ist dazu ausgelegt, eine Verbindung des ersten Widerstands (308) mit dem Kondensator (306) basierend auf der Schaltfrequenz des DC-DC-Wandlers (200) zu modulieren.

9. DC/DC-Wandler nach Anspruch 8, wobei:
die Kompensationsschaltung (300, 700) den ersten Schalter (312) aufweist, der dazu ausgelegt ist, den ersten Widerstand (308) mit dem Kondensator (306) zu koppeln; und
der erste Schalter (312) mit der Schaltersteuerschaltung (301) gekoppelt ist, um die Verbindung des ersten Widerstands (308) mit dem Kondensator (306) zu modulieren.

10. DC/DC-Wandler nach Anspruch 9, wobei:
die Kompensationsschaltung (300, 700) Folgendes aufweist:
der zweite Widerstand (310) ist mit dem Fehlerverstärker (302) gekoppelt; und
der zweite Schalter (314) ist dazu ausgelegt, den zweiten Widerstand (310) mit dem Kondensator (306) zu koppeln; und
der zweite Schalter (314) ist mit der Schaltersteuerschaltung (301) gekoppelt, um die Verbindung des zweiten Widerstands (310) mit dem Kondensator (306) zu modulieren.

11. DC/DC-Wandler nach Anspruch 10, wobei:
die Schaltersteuerschaltung (301) dazu ausgelegt ist, den ersten Widerstand (308) und den zweiten Widerstand (310) komplementär mit dem Kondensator (306) zu koppeln; und
die Zeit der Verbindung des ersten Widerstands (308) mit dem Kondensator (306) mit zunehmender Schaltfrequenz des DC-DC-Wandlers (200) zunimmt.

12. DC-DC-Wandler nach Anspruch 10, wobei ein Widerstandswert des zweiten Widerstands (310) größer als ein Widerstandswert des ersten Widerstands (308) ist.

13. DC/DC-Wandler nach Anspruch 10, wobei:
die Schaltersteuerschaltung (301) ausgelegt ist zum:
Erzeugen des ersten Schaltersteuersignals (Φ1), um den ersten Schalter (312) zu modulieren; und
Erzeugen des zweiten Schaltersteuersignals (Φ2), um den zweiten Schalter (314) zu modulieren; und
das zweite Schaltersteuersignal (Φ2) eine invertierte Version des ersten Schaltersteuersignals (Φ1) ist.

14. DC/DC-Wandler nach Anspruch 10, wobei:
die Kompensationsschaltung (700) Folgendes aufweist:
eine Kapazitätsvervielfacherschaltung, die Folgendes aufweist:
einen Pufferverstärker (702), der Folgendes aufweist:
einen Eingang, der mit einem Anschluss des Kondensators (306) gekoppelt ist; und
einen Ausgang; und
einen dritten Schalter (704), der zwischen den Ausgang des Pufferverstärkers (702) und den ersten Schalter (312) gekoppelt ist; und
das zweite Schaltersteuersignal (Φ2) den dritten Schalter (704) moduliert.

## Revendications

1. Convertisseur DC-DC (200) comprenant :
un amplificateur d'erreur (302) comprenant une sortie ;
un circuit de compensation (214, 300, 700) comprenant :
une première résistance (308) comprenant :
une première borne couplée à la sortie de l'amplificateur d'erreur (302) ; et
une deuxième borne ;
un premier commutateur (312) comprenant :
une première borne couplée à la deuxième borne de la première résistance (308) ; et
une deuxième borne ;
une deuxième résistance (310) comprenant :
une première borne couplée à la sortie de l'amplificateur d'erreur (302) ; et
une deuxième borne ;
un deuxième commutateur (314) comprenant :
une première borne couplée à la deuxième borne de la deuxième résistance (310) ; et
une deuxième borne couplée à une deuxième borne d'entrée de la première résistance (312) ;
un condensateur (306) comprenant :
une première borne couplée à la deuxième borne du premier commutateur (312) ; et
une deuxième borne couplée à la terre ; et
un circuit de commande de commutateur (301) comprenant une borne d'entrée (301A), configuré pour :
générer un premier signal de commande de commutateur (Φ1) pour commander la commutation du premier commutateur (312), et générer un deuxième signal de commande de commutateur (Φ2) pour commander la commutation du deuxième commutateur (314),
**caractérisé en ce que**
les rapports cycliques des premier et deuxième signaux de commande de commutateur (Φ1, Φ2) sont configurés pour évoluer avec la fréquence de commutation du convertisseur DC-DC (200) reçue à la borne d'entrée (301A), où le circuit de commande de commutateur (301) est configuré pour, au moyen des premier et deuxième signaux de commande de commutateur (Φ1, Φ2), fermer le premier commutateur (312) lorsque le deuxième commutateur (314) est ouvert, et ouvrir le premier commutateur (312) lorsque le deuxième commutateur (314) est fermé, et le circuit de commande de commutateur (301) est configuré pour coupler de manière complémentaire les première et deuxième résistances (308, 310) au condensateur (306) au moyen des premier et deuxième signaux de commande de commutateur (Φ1, Φ2).

2. Convertisseur DC-DC selon la revendication 1, dans lequel le circuit de compensation (700) comprend :
un amplificateur tampon (702) comprenant :
une entrée couplée à la première borne du condensateur (306) ; et
une sortie couplée à la première borne du premier commutateur (312).

3. Convertisseur DC-DC selon la revendication 2, dans lequel le circuit de compensation (700) comprend :
un troisième commutateur (704) comprenant :
une première borne couplée à la sortie de l'amplificateur tampon (702) ; et
une deuxième borne couplée à la première borne du premier commutateur (312).

4. Convertisseur DC-DC selon la revendication 1, dans lequel :
le premier commutateur (312) comprend une borne de commande ;
le deuxième commutateur (314) comprend une borne de commande ; et
le circuit de compensation (300) comprend un circuit de commande de commutateur (301) comprenant :
une première sortie de phase (301B) couplée à la borne de commande du premier commutateur (312) ; et
une deuxième sortie de phase (301C) couplée à la borne de commande du deuxième commutateur (314).

5. Convertisseur DC-DC selon la revendication 4, dans lequel le circuit de commande de commutateur (301) comprend :
une borne d'entrée (301A) ;
une porte logique (328), comprenant
une première entrée couplée à la borne d'entrée (301A) ;
une deuxième entrée ; et
une sortie ;
un circuit de retard (305) comprenant :
une entrée couplée à la borne d'entrée (301A) ; et
une sortie couplée à la deuxième entrée de la porte logique (328) ;
un premier inverseur (330) comprenant :
une entrée couplée à la sortie de la porte logique (328) ; et
une sortie couplée à la première sortie de phase (301B) ; et
un deuxième inverseur (332) comprenant :
une entrée couplée à la sortie du premier inverseur (330) ; et
une sortie couplée à la deuxième sortie de phase (301C).

6. Convertisseur DC-DC selon la revendication 5, dans lequel le circuit de retard (305) comprend :
une troisième résistance (320) comprenant :
une première borne couplée à la première entrée de la porte logique (328) ; et
une deuxième borne ;
un trigger de Schmitt (326) comprenant :
une entrée couplée à la deuxième borne de la troisième résistance (320) ; et
une sortie couplée à la deuxième entrée de la porte logique (328) ; et
un troisième condensateur (322) comprenant :
une première borne couplée à la deuxième borne de la troisième résistance (320) ; et
une deuxième borne couplée à la terre.

7. Convertisseur DC-DC selon la revendication 6, dans lequel le circuit de retard (305) comprend :
un troisième commutateur (318) comprenant :
une première borne couplée à la deuxième borne de la troisième résistance (320) ;
une deuxième borne couplée à la terre ; et
une borne de commande ; et
un troisième inverseur (316) comprenant :
une entrée couplée à la première borne de la troisième résistance (320) ; et
une sortie couplée à la borne de commande du troisième commutateur (318).

8. Convertisseur DC-DC selon la revendication 1, comprenant :
une borne de sortie ;
une source de tension de référence (303) ;
un amplificateur d'erreur (302) couplé à la borne de sortie et à la source de tension de référence (303), et configuré pour générer un signal d'erreur représentatif d'une différence entre une tension à la borne de sortie et une tension de référence fournie par la source de tension de référence (303) ;
le circuit de compensation (300, 700) couplé à l'amplificateur d'erreur (302) et comprenant :
la première résistance (308) couplée à l'amplificateur d'erreur (302) ; et
le condensateur (306) couplé à la première résistance (308) ; et
le circuit de commande de commutateur (301) configuré pour moduler la connexion de la première résistance (308) au condensateur (306) sur la base de la fréquence de commutation du convertisseur DC-DC (200).

9. Convertisseur DC-DC selon la revendication 8, dans lequel :
le circuit de compensation (300, 700) comprend le premier commutateur (312) configuré pour coupler la première résistance (308) au condensateur (306) ; et
le premier commutateur (312) est couplé au circuit de commande de commutateur (301) pour moduler la connexion de la première résistance (308) au condensateur (306).

10. Convertisseur DC-DC selon la revendication 9, dans lequel :
le circuit de compensation (300, 700) comprend :
la deuxième résistance (310) couplée à l'amplificateur d'erreur (302) ; et
le deuxième commutateur (314) configuré pour coupler la deuxième résistance (310) au condensateur (306) ; et
le deuxième commutateur (314) étant couplé au circuit de commande de commutateur (301) pour moduler la connexion de la deuxième résistance (310) au condensateur (306).

11. Convertisseur DC-DC selon la revendication 10, dans lequel :
le circuit de commande de commutateur (301) est configuré pour coupler de manière complémentaire la première résistance (308) et la deuxième résistance (310) au condensateur (306) ; et
le temps de connexion de la première résistance (308) au condensateur (306) augmente avec l'augmentation de la fréquence de commutation du convertisseur DC-DC (200).

12. Convertisseur DC-DC selon la revendication 10, dans lequel une résistance de la deuxième résistance (310) est supérieure à une résistance de la première résistance (308).

13. Convertisseur DC-DC selon la revendication 10, dans lequel :
le circuit de commande de commutateur (301) est configuré pour :
générer le premier signal de commande de commutateur (Φ1) pour moduler le premier commutateur (312) ; et
générer le deuxième signal de commande de commutateur (Φ2) pour moduler le deuxième commutateur (314) ; et
le deuxième signal de commande de commutateur (Φ2) est une version inversée du premier signal de commande de commutateur (Φ1).

14. Convertisseur DC-DC selon la revendication 10, dans lequel :
le circuit de compensation (700) comprend :
un circuit multiplicateur de capacité comprenant :
un amplificateur tampon (702) comprenant :
une entrée couplée à une borne du condensateur (306) ; et
une sortie ; et
un troisième commutateur (704) couplé entre la sortie de l'amplificateur tampon (702) et le premier commutateur (312) ; et
le deuxième signal de commande de commutateur (Φ2) modulant le troisième commutateur (704).
